# EUROPEAN PATENT APPLICATION

(11) **EP 4 723 456 A1**
(43) Date of publication of application: **08.04.2026**
(21) Application number: 25201921.1
(22) Date of filing: 12.09.2025
(51) Int. Cl.: H02M 1/00, H02M 3/157, H02M 3/158, H03F 3/217

(54) **CIRCUIT OF DRIFT DETECTION IN ELECTRIC SIGNAL FILTERS, CORRESPONDING DEVICE AND METHOD**

(30) Priority: 07.10.2024 IT 202400022233
(71) Applicant: STMicroelectronics International N.V., 1228 Plan-les-Ouates, Geneva (CH)
(72) Inventor: RAIMONDI, Marco, 20038 Busto Garolfo (Milano) (IT)
(74) Representative: Buzzi, Notaro & Antonielli d'Oulx S.p.A.

(57) **Abstract**

A circuit (10; 10') comprising a switching circuit block (12) comprising a node (SW) configured to provide a modulated signal (PWM); a low-pass filter circuit block (14) coupled to the switching node (SW) of the switching circuit block (12) to receive the modulated signal (PWM), the low-pass filter circuit (14) configured to apply low-pass filtering processing to the modulated signal (PWM) at a low-pass cut-off frequency, providing a demodulated signal (RPL) to a load impedance (Rload) as a result; a replicating circuit block (16) coupled to the switching node (SW) of the switching circuit block (12) to receive the modulated signal (PWM), the replicating circuit (16) configured to apply to the modulated signal (PWM) a replica of the low-pass filtering processing of the low-pass filter circuit (14), providing a reference signal (REF) as a result; a signal processing circuit block (20) coupled to the low-pass filter circuit (14) and to the replicating filter circuit (16), the signal processing circuit block (20) configured to apply signal processing to the demodulated signal (RPL) and to the reference signal (REF), providing at least one indicator signal (Vc, Vpp) indicative of a variation of the cut-off frequency of the at least one demodulator circuit block (14) as a result.

## Description

### Technical field

The description relates to methods and systems in electric signal filtering components.

One or more embodiments may be applied to drift detection and compensation in filtering components of audio amplification devices and/or switching converter circuits.

### Background

While the structure of a switching amplifier (such as a class-D power stage) is comparable to that of a switched-mode power supply, SPMS (such as a buck converter), the latter is configured to supply a constant voltage level to a variable load. Conversely, a class-D amplifier is configured to apply a variable voltage level to a fixed load.

While a switching amplifier may use any type of power supply (e.g., a car battery or an internal SMPS), the amplification process operates by switching and filtering via a LC demodulation filter.

For instance, document US 2023/0065469 A1 discusses an electronic device having a power rail that is driven by voltage regulators and provides a rail voltage, in which each voltage regulator has an output interface electrically coupled to the power rail to deliver up to a predefined regulator current to the power rail, wherein a voltage regulator controller has an input coupled to the output interface by a feedback path and controls a drive path coupled to the output interface, wherein a bypass unit is coupled to the drive path and voltage regulator controller and operates in a standby mode or an operational mode.

Existing switching amplifier topologies can have a feedback node coupled to an output of the LC filter. Therefore, the LC filter represents a block of a control loop. As a result, the range of acceptable values for its characteristics with respect to those expected from design become constrained in order to counter amplifier instability phenomena. For instance, amplifier instability may be triggered from a 50% drift of the filter components from their intended values.

Even after an accurate selection of the components at the stage of initial design and validation of the application, defects and aging on the field could lead to the aforementioned amplifier instability issues.

Stability, cost and area footprint of LC filter components represent relevant parameters for the application in switching amplifiers throughout the lifetime of the circuitry.

Existing solutions may use a one-time calibration cycle to find stable settings for open loop gain of a digital control loop comprising the LC filter. However, despite a correct selection of the components during the initial design and validation of the application, defects and aging on the field could lead to the mentioned issues.

### Object and summary

An object of one or more embodiments is to contribute in adequately addressing the issues discussed in the foregoing.

As the filter is a constant presence in switching amplifiers, there is an interest in reducing its cost and area footprint.

According to one or more embodiments, that object can be achieved via a circuit having the features set forth in the claims that follow.

One or more embodiments may relate to a corresponding electronic device.

One or more embodiments may relate to a corresponding method.

The claims are an integral part of the technical teaching provided herein with reference to the embodiments.

One or more embodiments facilitate providing a method of real-time detection of the values of the LC filter components. For instance, the method facilitates intercepting real-time defects or aging issues of a switching circuit.

One or more embodiments facilitates preventing circuit stability issues before they appear and facilitate maintenance of performance levels of amplifier circuits throughout their lifetime. For instance, the solution exploits the PWM modulation itself as test signal.

### Brief description of the several views of the drawings

One or more embodiments will now be described, by way of nonlimiting example only, with reference to the annexed Figures, wherein:
Figure 1 is a diagram of a circuit as per the present disclosure;
Figure 2 is a diagram of components of a circuit as per the present disclosure;
Figure 3, comprising portions a) and b), comprises diagrams of filter components in a circuit as exemplified in Figure 1;
Figure 4 is a diagram exemplary of principles underlying one or more embodiments;
Figure 5 is a diagram exemplary of an alternative circuit as per the present disclosure;
Figure 6 comprises a diagram exemplary of components in a circuit as exemplified in Figure 5;
Figure 7, comprising portions a) and b), comprises diagrams exemplary of components in a circuit as exemplified in Figure 5;
Figure 8 is a diagram exemplary of an evolution over time of signals suitable for use in one or more embodiments;
Figure 9 is a diagram exemplary of a method as per the present disclosure;
Figure 10, comprising portions a) and b), comprises diagrams of principles underlying one or more embodiments;
Figure 11, comprising portions a), b) and c), comprises diagrams of an evolution over time of signals in one or more embodiments; and
Figure 12 is a diagram exemplary of an alternative embodiment as per the present disclosure.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The references used herein are provided merely for convenience and hence do not define the extent of protection or the scope of the embodiments.

For the sake of simplicity, in the following detailed description a same reference symbol may be used to designate both a node/line in a circuit and a signal which may occur at that node or line.

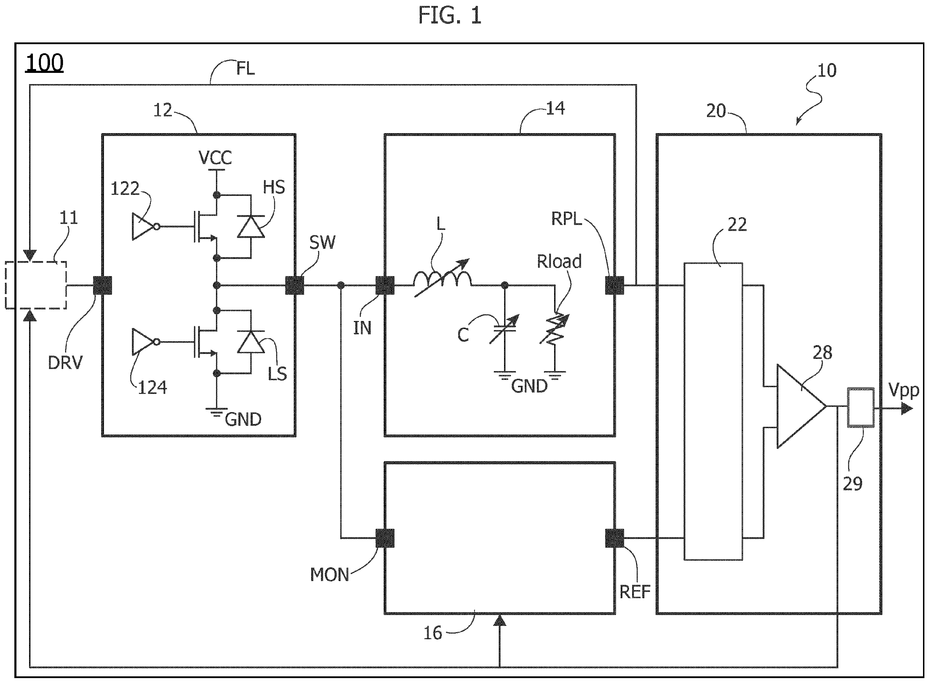

As exemplified in Figure 1, an electronic device 100 as per the present disclosure (such as a class D amplifier, for instance) comprises a circuit 10, comprising:
a switching circuit block 12 comprising an input node configured to receive a modulated signal DRV to drive a half-bridge arrangement (per se known) of switches HS, LS via respective drive nodes 122, 124, the switching stage 12 further comprising a switching node configured to provide a switching signal PWM, such as a pulse-width modulated signal;
a demodulator circuit block 14 comprising an input node IN coupled to the switching node SW to receive the switching signal PWM therefrom, the demodulator circuit block 14 comprising a filter circuit network comprising reactive circuit components (such as an inductive circuit element L, a capacitive circuit element C and/or an optional snubber network to limit the quality factor, for instance) and a load element R (such as an audio speaker, for instance), the filter circuit block 14 comprising an output node configured to provide a ripple signal RPL, that is the residual periodic variation of the voltage applied to the load R;
a replicator circuit block 16 comprising an input node MON coupled to the switching node SW of the switching circuit 12 to receive the switching signal PWM therefrom, the replicator circuit block 16 configured to vary its properties (e.g., in real time) based on a control signal Vc in order to mirror the behavior of the demodulator circuit block 14 at the frequency of the switching signal PWM, thereby providing a reference signal REF at an output node;
a monitoring circuit block 20 coupled to the demodulator circuit block 14 to receive the demodulated signal RPL therefrom and to the replicator circuit block 16 to receive the reference signal REF, the monitoring circuit block 20 comprising circuitry configured to detect a difference among the received signals RPL, REF, thereby measuring a drift in the ripple of the demodulated signal RPL to provide a feedback indicator Vc of an estimated drift of the cut-off frequency of the LC filter in the demodulator circuit block 14 with respect to the nominal value of the components of the replicator circuit block 16; optionally, the monitoring circuit block 20 is configured to further provide a post-processed version Vpp of the feedback indicator Vc in order to facilitate its use by user circuits, as discussed in the following.

Optionally, the device 100 exemplified in Figure 1 further comprises a modulator circuit 11 configured to convert an analog input (e.g., audio) signal into the drive signal DRV for the switching circuit 12.

For instance, the monitoring circuit block 20 can advantageously process a version of the ripple signal at the frequency of the carrier PWM signal that is scaled with respect to the power supply level at the output of respective circuit blocks 14, 16.

As appreciable by the person skilled in the art, capacitors and inductors are "reactive" components insofar as they store/release energy based on changes in applied voltage or current.

As exemplified in Figure 1, there is a feedback loop FL from the output of the filter circuit 14 and/or switching circuit 12 back to the modulator circuit 11 (when present), in a manner per se known.

As exemplified in Figure 1, in addition to being used for diagnostic purposes, the feedback indicator Vc can be also provided to the modulator circuit 11 in order to compensate, e.g., real-time, the poles of a gain |Gloop| of the feedback loop FL (e.g., introducing compensating zeros) based on the measured real-time cut-off frequency of the reactive elements L,C of the filter circuit block 14 via the replica circuit 16.

Optionally, the feedback indicator Vc may also or alternatively be used to tune the frequency of the zeros for compensating the poles based on the measured (e.g., real-time) cut-off frequency of the reactive elements L,C of the demodulator circuit block 14.

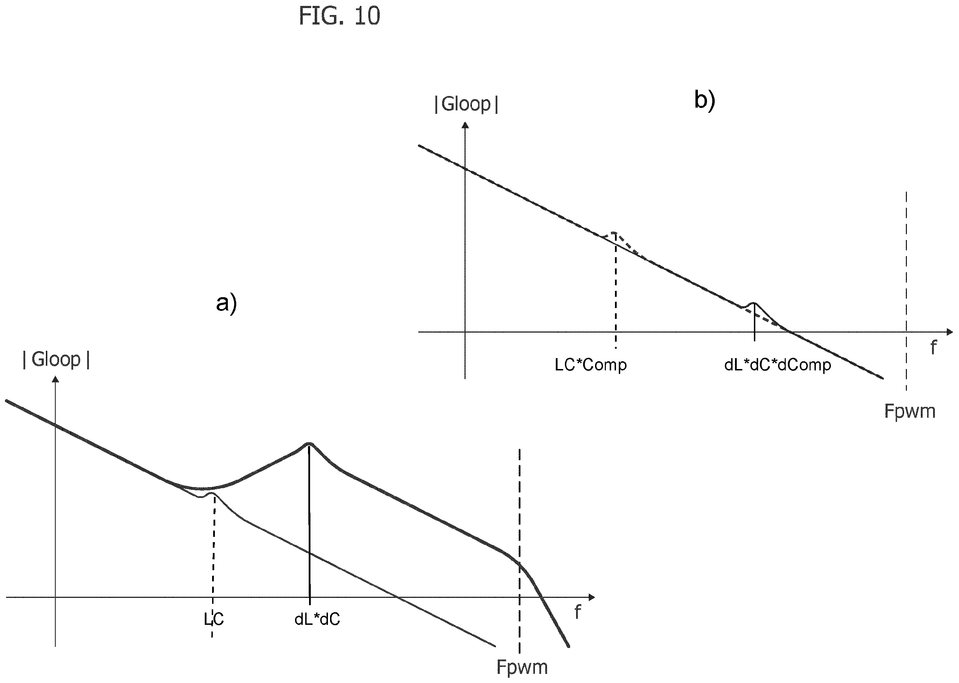

Portion a) of Figure 10 is a diagram exemplary of a gain magnitude |Gloop| of the feedback loop (ordinate scale, in arbitrary units) versus frequency (abscissa scale, in Hertz units) in a conventional circuit. As exemplified in portion a) of Figure 10, an ideal case in which the properties of the filter circuit 14 do not vary (thinner solid line plot) is illustrated side-by-side a more realistic case in which there is a drift (or derating) dL*dC among properties of the filter circuit 14 (thicker solid line plot), leading to a shift (or detuning) in the resonance frequency.

For instance, in case the feedback FL is coupled at the output of the circuit block 14, the aforementioned shift of the resonance frequency (briefly, detuning) may lead to instability in the feedback loop.

Portion b) of Figure 10 is a diagram exemplary of the gain magnitude |Gloop| of the same feedback loop (ordinate scale, in arbitrary units) versus frequency (abscissa scale, in Hertz units) in a scenario as per the present disclosure where there is the possibility of compensating the shift of the poles of the gain via a corresponding shift in the compensating zeros based on the feedback indicator Vc, thereby maintaining stability in the feedback loop FL, whose tuning is thereby restored.

As exemplified in portion b) of Figure 10, thanks to the possibility to have at least one compensating zero (preferably, two compensating zeros to match the number of poles in the LC filter 14), it is possible to match the drift dC*dL of the properties of the filter circuit 14, thereby maintaining the performance of the circuit 10.

As exemplified in Figure 1, the monitoring circuit comprises a differential amplifier circuit 28 coupled to the modulator 14 and the replicator 16 to receive the ripple signal RPL and reference signal REF therefrom, the differential amplifier circuit 28 configured to provide a signal indicative of a difference between the signals RPL, REF (or a difference between signals processed based on RPL, REF, such as signals RPL_P, REF_P as discussed in the following).

For instance, a method as per the present disclosure comprises sensing a difference ε between the sensed ripple RPL downstream the reactive circuitry LC of the demodulator 14 and the replica ripple REF sensed downstream the dummy circuit 16, thereby facilitating normalization of the measure with respect to PWM output values, estimating ripple deviation with respect to target nominal values.

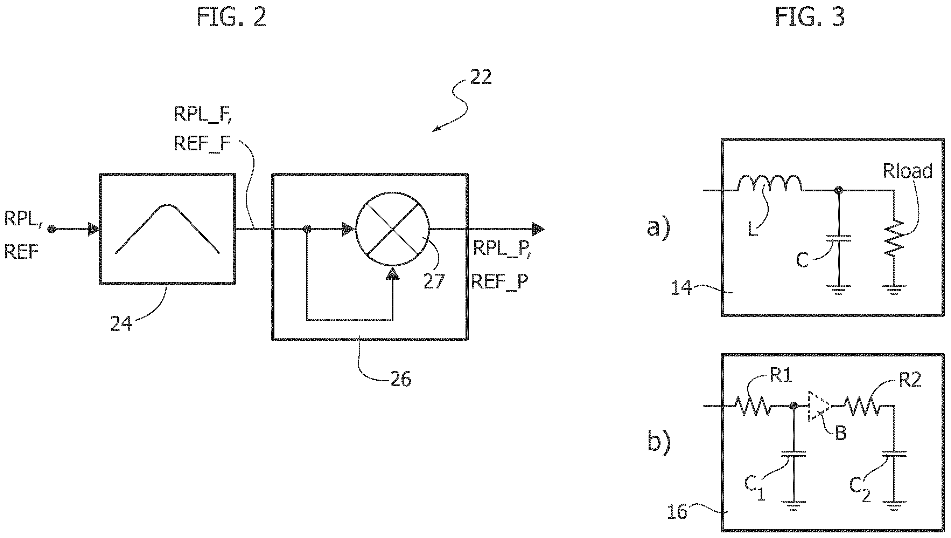

As exemplified in Figures 1 and 2, the monitoring circuit 20 comprises a signal processing stage 22 comprising:
a pass-band filter circuit block 24 configured to receive one or both the filtered signals RPL, REF and to apply pass-band filtering thereto, the pass-band filter 24 having a center frequency about the carrier frequency of the switching signal PWM; and
a power detecting circuit block 26 coupled to the pass-band filter circuit block 24 to receive the filtered signals therefrom and to apply signal processing thereto, providing a processed signal RPL_P, REF_P of the pass-band filtered ripple signal(s).

In one or more embodiments, the pass-band filter circuit block 24 facilitates increasing signal-to-noise ratio (SNR).

For instance:
filtering the lower band of the spectrum of the signal RPL, REF facilitates removing the DC contribution in case of a DC-DC converter circuit or of the audio signal in case of audio amplifier;
filtering the higher band facilitates removing higher order harmonics of the PWM frequency and possible spikes.

As exemplified in Figure 2, the pass-band filter 24 facilitates, e.g., extracting a measure of the magnitude of the frequency response of the LC filter at the frequency of the PWM signal SW.

In one or more embodiments, the monitoring circuit 20 provides a measure of magnitude and/or power of the ripple signal(s).

As exemplified in Figure 2, the power detecting circuit block 26 comprises a multiplier circuit 27 configured to provide the (e.g., average) signal power RPL_P, REF_P by multiplying the respective filtered signal RPL_F, REF_F by itself (e.g., as the average signal power scales with the square of the signal).

In an alternative exemplary scenario, the multiplier 27 may perform multiplication of the filtered signal RPL_F, REF_F and its sign value, in order to simplify circuit complexity at the cost of a negligible SNR decrease.

In a further alternative exemplary scenario, the circuit block 27 comprises an envelope detector to measure peak power value of the signal(s) RPL_F, REF_F.

As exemplified in Figure 1, the device 10 comprises a comparator 28 configured to compare the power RPL_P of the (filtered) ripple signal RPL with the power REF_P of the (filtered) reference signal REF.

As exemplified in portion a) of Figure 3, the demodulator circuit block 14 comprises a LC circuit coupled to a load resistance Rload.

As exemplified in portion b) Figure 3, the replicator circuit block 16 comprises circuitry configured to mirror the transfer function of the LC filter 14 at the frequency of the switching signal PWM.

As appreciable to those of skill in the art, the PWM frequency can be appreciably higher than the cut-off frequency of the LC filter in the demodulator circuit block 14. Therefore, the transfer function of the LC filter at PWM frequency can be considered decoupled from quality factor depending on load or snubber circuits, for instance. As a result, the circuit complexity of the replicator circuit block 16 can be advantageously reduced.

For instance, the replicator circuit block 16 comprises a cascade of two first-order filters, such as RC filter circuits R₁, C₁ and R₂, C₂. Optionally, the replicator circuit block 16 further comprises a buffer B interposed therebetween, as exemplified in Figure 3.

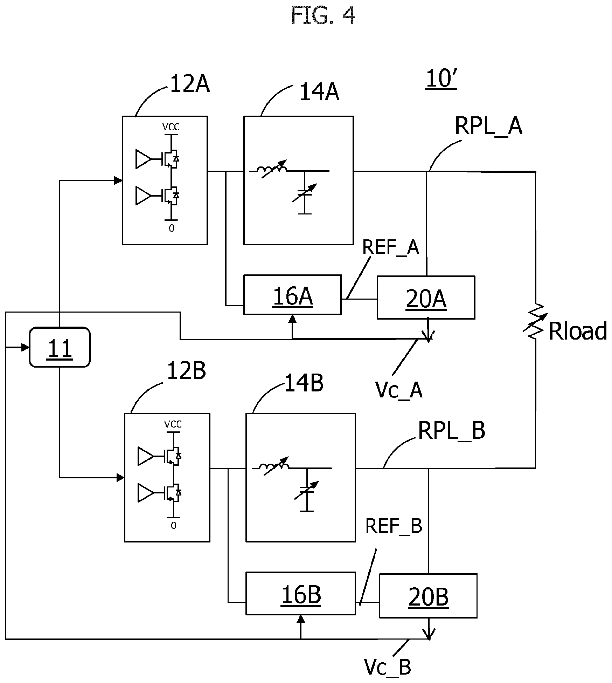

For the sake of simplicity, in the following one or more embodiments are mainly discussed with reference to the case in which there is a single load Rload coupled to the filter circuit 14, as exemplified in Figure 1. Such a scenario is purely exemplary and in no way limiting as one or more embodiments can comprise a plurality of filter circuits 14A, 14B coupled to a common load Rload, as exemplified in Figure 4.

As exemplified in Figure 4, an alternative circuit 10' comprises:
a set of switching circuit blocks 12A, 12B having respective switching nodes configured to provide PWM switching signals based on at least one drive signal received from at least one modulator circuit 11;
a set of demodulator circuit blocks 14A, 14B coupled to the switching nodes of respective switching circuit blocks 12A, 12B to receive the respective PWM switching signals therefrom, the demodulator circuit blocks 14A, 14B each comprising a filter circuit network comprising reactive circuit components (such as an inductive circuit element L, a capacitive circuit element C and/or optionally a snubber RC circuit in parallel to the capacitive element, in order to limit the quality factor, in a manner per se known) and configured to be coupled across a common load element Rload (such as an audio speaker, for instance), the filter circuit blocks 14A, 14B comprising output nodes configured to provide output signals RPL_A, RPL_B, respectively;
a set of replicator circuit blocks 16A, 16B coupled to the switching nodes of the switching circuits 12A, 12B to receive the PWM switching signals therefrom, the replicator circuit blocks 16A, 16B each configured to vary its properties (e.g., vary the cut-off frequency in real time) based on a respective control signal Vc_A, Vc_B in order to mirror the behavior of the respective demodulator circuit block in the set of demodulator circuit blocks 14A, 14B at the frequency of the respective PWM switching signal, thereby providing a respective reference signal REF_A, REF_B;
a set of monitoring circuit blocks 20A, 20B each coupled to the demodulator circuit blocks 14A, 14B and to the replicator circuit blocks 16A, 16B, the monitoring circuit blocks 20A, 20B comprising circuitry configured to provide indicator signals Vc_A, Vc_B based on a detected difference among the received signals RPL_A, RPL_B, REF_A, REF_B thereby measuring a drift in the respective ripple of the demodulated signals RPL_A, RPL_B to provide respective feedback indicators Vc_A, Vc_B of estimated drifts of the cut-off frequency of the LC filters 14A, 14B with respect to the nominal design values.

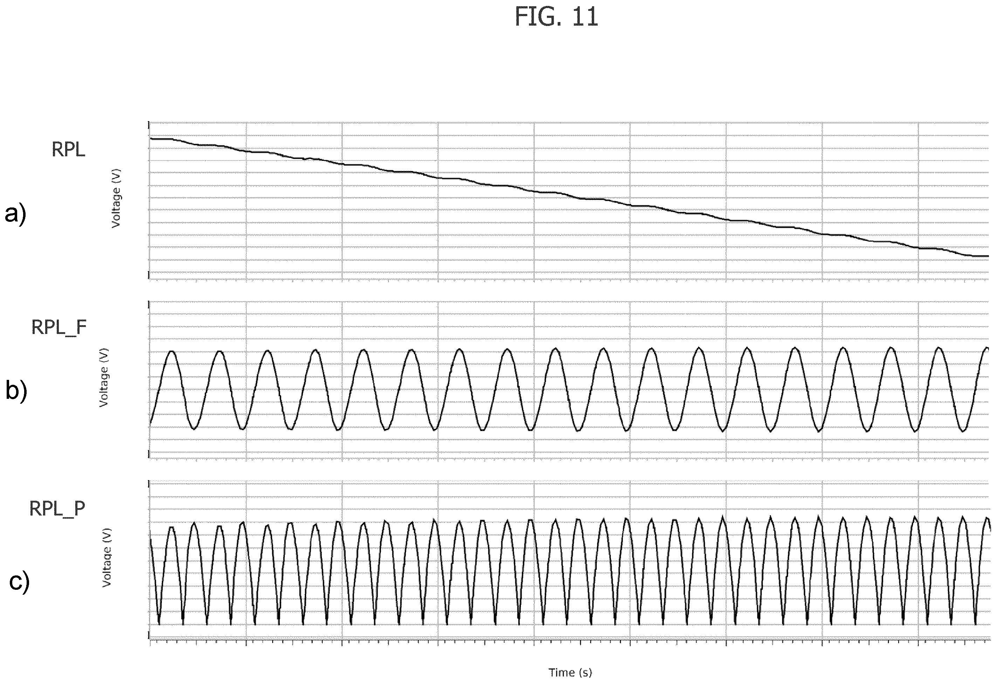

As appreciable to those of skill in the art and as exemplified in portion a) of Figure 11, the signal RPL received from the filter circuit 14 comprises not only the ripple from the carrier signal but also the demodulated audio signal (in case the circuit 10 is used in an audio amplifier) or the DC signal (in case the circuit is used in a DC-DC converter circuit).

As a result of applying pass-band filtering 24 to the signal RPL, the carrier ripple RPL_F is extracted, as exemplified in portion b) of Figure 11.

As exemplified in portion c) of Figure 11, the result of the filtered signal RPL_F times its sign value provides the power signal RPL_P.

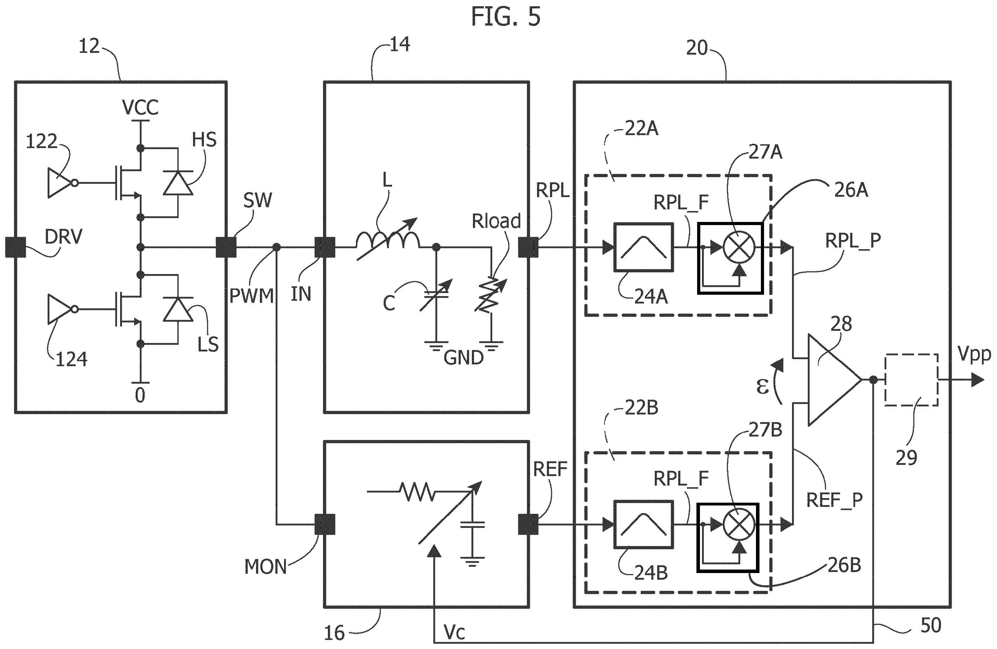

As exemplified in Figure 5, the signal processing circuit block 22 comprises a first signal processing branch 22A and a second signal processing branch 22B each comprising respective pass-band filters 24A, 24B and circuits 27A, 27B for parallel processing of respective ripple signal RPL and reference signal REF.

As exemplified in Figure 5, the replicator circuit block 16 comprises tunable electric components whose properties may be varied via feedback branch 50, for instance providing the feedback signal Vc as a digital control code comprising a plurality of bits Vc(1),...,Vc(i),...,Vc(N).

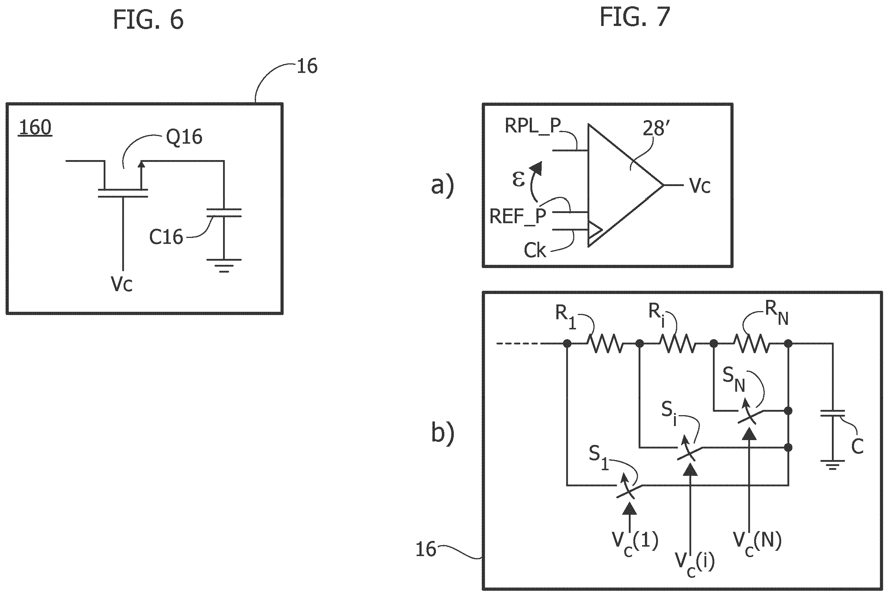

As exemplified in Figures 5 to 7 and 12, it is possible to vary the electric component values in the replicator circuit block 16 according to:
an analogic control scheme, as exemplified in Figure 6, where the feedback branch 50 provides the control signal Vc for an analogic component of the replicator circuit block 16, such as a variable resistance of the active element Q16 (e.g., a MOSFET transistor) as discussed in the following;
a digital control scheme, as exemplified in portion b) of Figure 7, where the control signal Vc is a digital code, whose bits are used to selectively couple (e.g., if the bit is asserted high) or decouple (e.g., if the bit is asserted low or deasserted) modules of an (e.g., series) arrangement of electric modules (e.g., each comprising a capacitive element).

As exemplified in Figures 5 to 7, a cutoff frequency of the replicator or dummy circuit 16 is variable based on the feedback indicator Vc as control signal.

As exemplified in Figure 5, the monitoring circuit 20 comprises an error amplifier circuit 28 configured to generate a signal Vc indicative of a difference ε between the output power from the processed signal from LC filter 14 and from the replicator or "dummy" circuit 16, for instance using an embedded integrator circuit.

In one or more embodiments the monitoring circuit 20 is implemented in analogic, digital and/or mixed technology.

In an exemplary analog implementation case illustrated in Figures 5 and 6, the monitoring circuit 20 and the replicator circuit 16 can be implemented using analog technology. As exemplified in Figure 6, the replicator circuit 16 comprises non-linear components 160, for instance an active circuit element Q16 (such as a MOSFET or other type of transistor, for instance) having on-resistance and/or capacitance values R₁₆, C₁₆ vary based on the analog feedback signal Vc. For instance, the active circuit element Q₁₆ comprises a MOSFET transistor with variable on-resistance R₁₆ whose values can be controlled by providing the control signal Vc at the gate of the transistor Q₁₆.

For the sake of simplicity, the Figures mainly relate to exemplary scenarios envisaging adjustable pole(s), being otherwise understood that in one or more embodiments the same principles may be applied mutatis mutandis to providing adjustable zero(s).

In another exemplary scenario illustrated in portions a) and b) of Figure 7, the monitoring circuit 20 and the replicator circuit 16 employ the digital control scheme discussed in the foregoing.

As exemplified in portion a) of Figure 7, the monitoring circuit 20 comprises an error amplifier 28' comprising a further input node CK configured to receive a digital clock signal to provide timed updates of the control signal values Vc.

In the exemplary case illustrated in portion b) of Figure 7, the control signal Vc is a digital signal comprising a plurality of bits Vc(1),Vc(i),Vc(n) which can be used to drive switches S₁, Sᵢ, S_{N} to couple respective resistive elements R₁, Rᵢ, R_{N} to a capacitive element C, thereby varying the properties of the replicator 16.

It is noted that the number of three resistive elements R₁, Rᵢ, R_{N} and switches S₁, Sᵢ, S_{N} exemplified in portion b) of Figure 7 is purely exemplary and in no way limiting as notionally any number of resistive elements and switches may be present to be driven by respective bits of the control signal Vc.

For instance, as an i-th control bit Vc(i) has a first logic value (e.g., "high" or "1") the corresponding i-th switch Si may be driven to be in a first logic state (e.g., "closed"), thereby coupling the respective i-th resistive element Ri to the capacitive element C.

In case the amplifier circuit enters a clipping phase, the switching at the switching node SW stops. Therefore, signals RPL e REF can hardly be meaningful and the control signal Vc is to be kept "on hold" until laps of the clipping phase (that is, as soon as the PWM signal starts switching again).

In one or more embodiments, the accuracy of the circuit 10 is a function of an absolute value of the cutoff frequency of the LC filter replicator. For instance, in order to counter process variations, trimming by the product engineer may be applied to replicator components.

For instance, in case a low-quality capacitor is used, an equivalent series resistance (ESR) thereof can result in a singularity close to the carrier frequency of the PWM signal. One or more embodiments as per the present disclosure monitoring the (approximate) power of the ripple facilitate providing a diagnostic tool which is equivalent to an LC filter without ESR but with a higher cutoff frequency, equating the effect on the ripple for the purpose of monitoring the goodness of the LC filter.

In one or more embodiments, the proposed arrangement 10 may be applied in a context in which there is a real time adaptation for an amplifier with feedback coupled to the LC filter. For instance, such an exemplary scenario facilitates increasing a trade-off between performance and stability depending on the quality of the components equipped on-board the application.

As exemplified in Figure 5, the monitoring circuit block 20 optionally comprises a further signal processing circuit block 29 coupled to the comparator circuit 28 to receive the feedback indicator Vc therefrom, the further signal processing circuit block 29 configured to apply signal (post-)processing (e.g., filtering and/or decimation and/or sampling, in a manner per se known) to the feedback indicator Vc, providing a processed indicator signal Vpp to user circuits.

As exemplified in Figure 5, the further signal processing circuit block 29 facilitates providing the processed indicator signal Vpp in a form easier to use by an application. For instance, the user circuit comprises a printed-circuit board (PCB) comprising a plurality of integrated circuits (ICs). In the example considered, the processed indicator signal Vpp can be provided to an inter-IC bus (briefly, I2C) o Inter-IC sound interface (12S).

As appreciable to the person skilled in the art:
- I2C is a low speed and two wire serial data connection bus used to run signals between ICs mounted on the same printed circuit board PCB used in various applications, including connecting microcontrollers to peripherals such as sensors, EEPROMs, and other peripherals in embedded systems.
- I2S is a specialized communication protocol for exchanging digital audio data between integrated circuits, such as digital signal processors (DSPs) and audio codecs; the protocol supports multiple audio formats, including stereo audio, and is capable of handling different sample rates and bit depths and is commonly used in audio applications like connecting digital audio processors to digital-to-analog converters (DACs) or analog-to-digital converters (ADCs).

Both protocols are integral in modern electronic designs, each catering to specific communication needs.

In such an exemplary scenario, the presence of the further processing signal circuit block 29 facilitates providing a processed indicator signal Vpp that is a digital version at lower frequency and higher resolution of the indicator Vc.

For instance, in case the indicator Vc is an analog signal, the further processing circuit block 29 is configured to apply time sampling and amplitude quantization thereto, optionally after an anti-aliasing filtering operation, therefore providing the processed indicator signal Vpp in a data format that can be handled directly by an I2C or I2S interface.

In an alternative example, in case the feedback indicator Vc is a digital signal, it can still be advantageously to apply further processing 29 thereto insofar as the frequency of the digital indicator Vc can be at hundreds of kHz while the I2C/I2S interfaces may operate at lower frequencies (e.g., 44.1kHz - 192kHz). Moreover, the control signal Vc may have a few bits of resolution based on the number of selectable modules (S₁,R₁),...,(Si,Ri),...,(S_{N},R_{N}) employed for implementing the replica circuit 16, as discussed with reference to Figure 7. Therefore, in the example considered, the further signal processing circuit block 29 may be configured to apply a decimation processing to the digital control signal Vc, for instance computing an average among two consecutive signal samples, obtaining an extra quantization level (that is, increasing the signal resolution) while reducing (e.g., halving) the frequency of the signal.

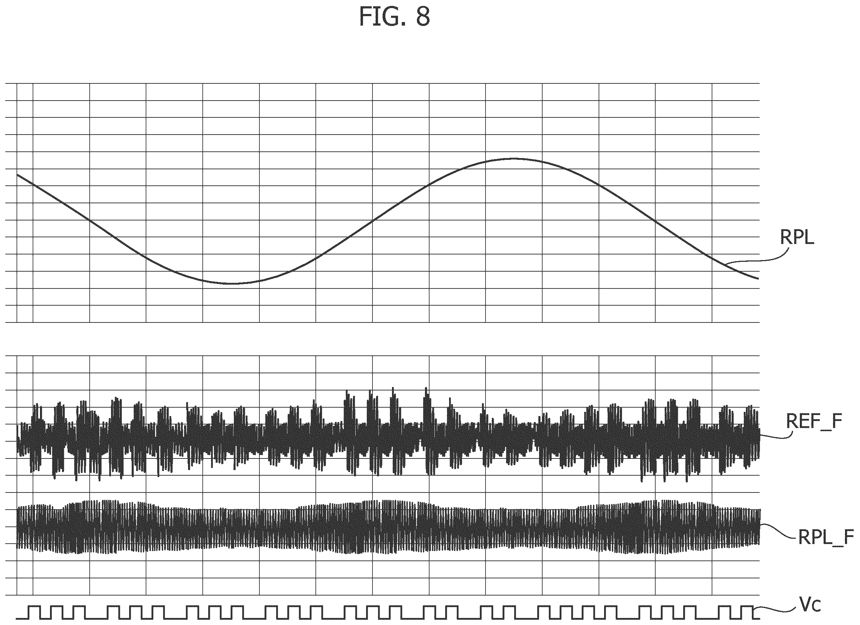

Figure 8 is a plot diagram exemplary of an evolution over time (abscissa axis) of the magnitude (ordinate axis) of signals RPL, REF_F, RPL_F, Vc suitable for use in one or more embodiments. For instance, in the case exemplified in Figure 8 the error amplifier 28 comprises and integrator and is clocked via digital clock signal CK, the replicator circuit 16 employs the digital implementation exemplified in portion b) of Figure 7 and the processed signals RPL_P, REF_P are obtained by multiplying the signal RPL_F, REF_F with respective sign values. As exemplified in Figure 8, the signal REF_F has a "jerky" evolution that matches the evolution of the digital control signal Vc triggered by the clock signal CK.

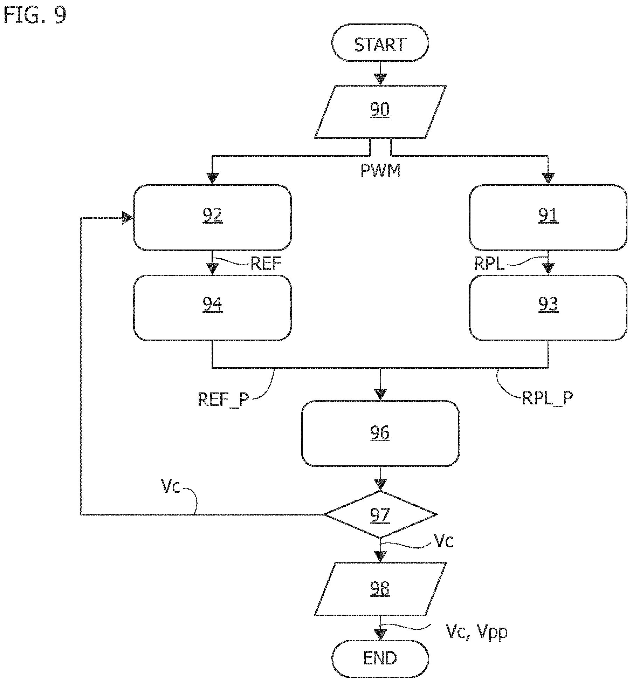

As exemplified in Figure 9, a method as discussed herein comprises:
block 90: providing a switching circuit block 12 (e.g., of a class-D amplifier) comprising a switching node SW configured to provide a modulated signal PWM;
block 91: coupling a demodulator circuit block 14 comprising a LC network to the switching node SW of the switching circuit block 12, providing a ripple signal RPL as a result of applying demodulation processing 14 to the modulated signal PWM;
block 92: coupling a replicator circuit block 16 to the switching node SW of the switching circuit block 12, the replicator circuit block 16 configured to mirror the behavior of the demodulation circuit block 14 at a frequency of the modulated signal PWM, providing a reference ripple signal REF as a result;
block 93: applying signal processing to the ripple signal RPL, obtaining a processed ripple signal RPL_P indicative of the power of the ripple signal RPL;
block 94: applying signal processing to the reference signal REF, obtaining a processed reference signal REF_P indicative of the power of the reference signal REF;
block 96: calculating a difference (or error signal, and preferably further amplifying the difference) among the processed ripple signal RPL_P and the processed reference signal REF_P;
block 97: preferably, providing the calculated (and amplified) error signal or difference as a control signal Vc to the replicator circuit block 16 and performing frequency tuning of the circuit block;
block 98: providing the calculated/amplified difference or error signal as feedback indicator signal Vc or alternatively as a processed signal indicator Vpp, for instance to the modulator circuit block 11 coupled to the switching stage 12 for tuning circuit zeros and/or to user circuits employing I2S/I2C interfaces. As exemplified herein, the goal is to reach a point at which the amplifier difference is close to zero. For instance, as soon as the condition above is reached the replica circuit 16 is "tracking" the drift of the elements of the filter circuit 14 with respect to their nominal values.

In a first exemplary scenario, the method comprises sensing a ripple downstream the LC filter based the PWM drive signal as a test signal. The sensed ripple is a function of the transfer function of the LC filter itself, in particular of the LC product that defines the location of the poles. Therefore, a difference between the sensed power signal RPL_P and the sensed power signal replica REF_P indicates a ripple variation.

For instance, the sensed ripple is also based on the output levels of the PWM power stage, which can be modeled as a noise with respect to the desired measured values. In particular, the noise can be compensated by the fact that the replica circuit block 16 is subject to the same variations of the output PWM signal levels. Therefore, in measuring a difference among the two signals, noise effects get compensated (thanks to the proportionality of both quantities to equate to a same power supply level).

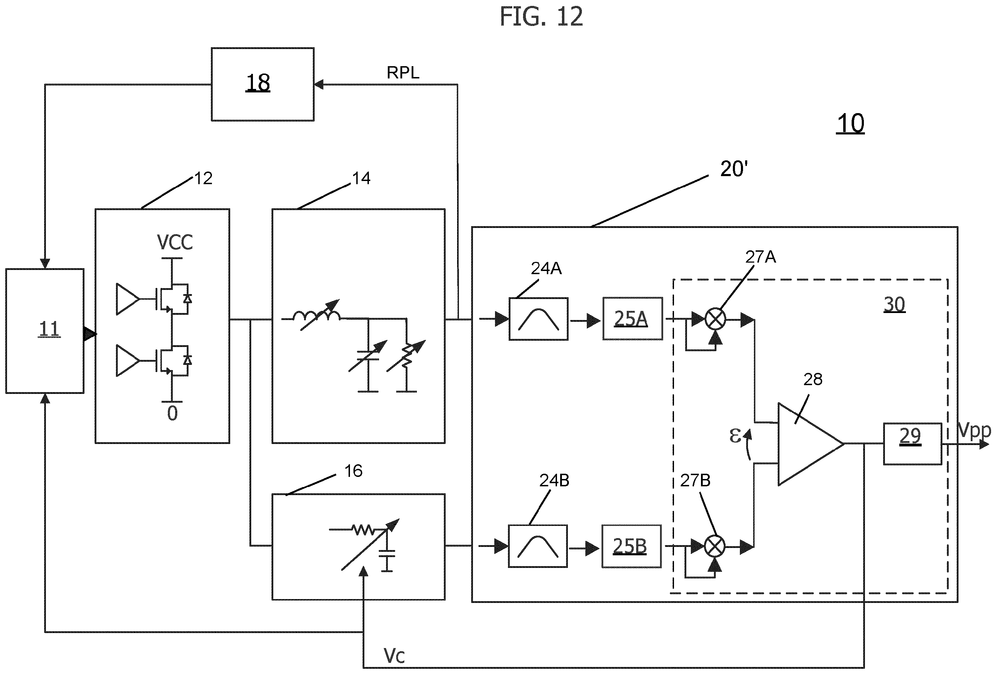

In alternative scenario as exemplified in Figure 12, the modulator circuit block 11 comprises a digital logic circuit block; the feedback loop FL comprises an analog-to-digital converter, ADC 18 interposed the output node of the demodulator circuit 14 and the modulator circuit block 11, and the control signal Vc is provided to the modulating circuit block 11 as a digital code word.

As exemplified in Figure 12, one or more parts of monitoring circuit 20' comprise a digital part 30. For instance, the digital part 30 can be coupled to a set of analog-to-digital converter circuits, ADCs 25A, 25B comprising a first ADC 25A interposed the first pass-band filter 24A and the first multiplier circuit 27A and a second ADC 25B interposed the second pass-band filter 24B and the second multiplier circuit 27B.

As exemplified in Figure 12, the replicator circuit 16 implements a digital control (as exemplified in portion b of Figure 7) via digital control signal Vc.

In the exemplary scenario exemplified in Figure 12, the compensation of a shift of the LC filter poles with real-time variable zeros can be performed digitally, e.g., by varying the values of digital zeros at the modulator circuit block 11 based on digital control signal Vc.

It is noted that the example of Figure 12 is non limiting as the digital part 30 can be present in variant embodiments also in the presence of an analog modulator circuit block 11.

As exemplified herein, a circuit 10 comprises at least one switching circuit block 12; 12A, 12B comprising:
a supply node VCC configured to receive a supply voltage level from an energy source referred to ground GND;
a control node DRV configured to receive an input signal;
a switching node SW configured to provide a modulated signal PWM;
a first electronic switch HS having a current flow path therethrough coupled interposed to the supply node and the switching node;
a second electronic switch LS having a current flow path therethrough coupled interposed to the switching node and ground.

For instance, the first electronic switch and the second electronic switch are configured to be made selectively conductive and non-conductive based on the input signal received at the second node, providing at least one modulated signal PWM at the switching node as a result.

As exemplified herein, the circuit further comprises:
at least one demodulator circuit block 14; 14A, 14B coupled to the switching node of the at least one switching circuit block to receive the at least one modulated signal, the demodulator circuit 14 configured to apply low-pass filtering processing to the modulated signal at a low-pass cut-off frequency, providing at least one demodulated signal RPL; RPL_A, RPL_B to at least one load impedance Rload as a result;
at least one replicating circuit block 16; 16A, 16B coupled to the switching node of the at least one switching circuit block to receive the at least one modulated signal, the at least one replicating circuit configured to apply to the at least one modulated signal a replica of the low-pass filtering processing of the at least one demodulator circuit, providing at least one reference signal REF; REF_A, REF_B as a result;
at least one signal processing circuit block 20; 20A, 20B coupled to the at least one demodulator circuit and to the at least one replicating filter circuit, the at least one signal processing circuit block configured to apply signal processing to the at least one demodulated signal and to the at least one reference signal, providing at least one sensing signal Vc; Vc_A, Vc_B Indicative of a variation of the cut-off frequency of the at least one demodulator circuit block as a result.

As exemplified herein:
the circuit comprises at least one feedback loop FL coupling the at least one demodulator circuit to the control node of the at least one switching circuit block via a modulating circuit block 11, and varying a loop gain frequency response |Gloop| based on the indicator signal.As exemplified herein, the signal processing circuit is configured to provide the indicator signal back to the replicating filter circuit block, varying a cut-off frequency of the replica of the at least one demodulator circuit block is based on at least one indicator signal.

As exemplified in Figure 4, the circuit comprises:
a first switching circuit block 12A and a second switching circuit block 12B each comprising a respective supply node configured to receive a supply voltage level from an energy source referred to ground, a respective control node configured to receive an input signal, and a respective switching node configured to provide a respective modulated signal;
a first demodulator circuit block 14A coupled to the switching node of the first switching circuit block to receive a first modulated signal and a second demodulator circuit block 14B coupled to the switching node of the second switching circuit block to receive a second modulated signal;
a first replicating circuit block 16A coupled to the switching node of the first switching circuit block 12A to receive the first modulated signal and a second replicating circuit block 16B coupled to the switching node of the second switching circuit block to receive the second modulated signal;
the first 16A, resp. second 16B, replicating circuit configured to apply to the first, resp. second, modulated signal a replica of the low-pass filtering processing of the first, resp. second, demodulator circuit, providing a first REF_A, resp. second REF_B reference signal as a result.

As exemplified in Figure 4, the circuit comprises:
A first signal processing circuit block 20_A configured to perform a comparison of a first power signal based on the first demodulated signal RPL_A and a second power signal based on the first reference signal REF_A, providing a first feedback indicator signal Vc_A as a result of the comparison, the first feedback indicator signal Vc_A indicative of a variation of the cut-off frequency of the first demodulator circuit block 14A, and
a second signal processing circuit block 20_B configured to perform a comparison of a third power signal based on the second demodulated signal RPL_B and a fourth power signal based on the second reference signal REF_B, providing a second indicator signal Vc_B as a result of the comparison, the second indicator signal Vc_B indicative of a variation of the cut-off frequency of the second demodulator circuit block 14B.

As exemplified herein, the signal processing circuit block comprises:
a first signal processing branch 22A configured to apply a first signal processing 24A, 26A to the demodulated signal RPL received from the at least one demodulator circuit block 14, providing a first processed signal RPL_P as a result;
a second signal processing branch 22B configured to apply a second signal processing 24B, 26B to the reference signal received from the replicating filter circuit block, providing a second processed signal REF_P as a result; and
a differential amplifier circuit block having a first error amplifier node coupled to the first signal processing branch to receive first processed signal and a second error amplifier node coupled to the second signal processing branch to receive the second processed signal, the error amplifier configured to produce the at least one indicator signal based on a difference ε between the first processed signal and the second processed signal.

As exemplified herein, the first signal processing branch 22A and the second signal processing branch 22B each comprise:
a pass-band filter circuit block 24 configured to apply pass-band filtering to the received input signal, providing a pass-band filtered signal RPL_F, REF_F as a result, and
a power detecting circuit block 26 coupled to the pass-band filter circuit block and configured to apply power detection processing to the pass-band filtered signal, providing the processed signal RPL_P, REF_P as a result.

For instance, the error amplifier circuit block comprises an integrator.

For instance, the power detecting circuit block comprises:
multiplier circuitry 27; 27A, 27B configured to provide a power signal by multiplying the pass-band filtered signal by itself or by detecting a sign of the pass-band filtered signal and multiplying the pass-band filtered signal by the detected sign; and/or
envelope detecting circuitry configured to measure a peak power of the pass-band filtered signal.

As exemplified herein, the signal processing circuit is configured to provide the indicator signal back to the replicating filter circuit block, and a cut-off frequency of the replicating circuit block (16) varies based on the received indicator signal.

For instance, the at least one replicating circuit block comprises active filter circuitry R1, C1, R2, C2; Q16.

As exemplified herein, the at least one replicating circuit block comprises an active circuit element Q16, preferably comprising a transistor, having a control node configured to receive the indicator signal and a current flow path therethrough coupled to a capacitive element C16, wherein a resistance of the active circuit element varies based on the indicator signal.

As exemplified herein, for instance:
the error amplifier circuit block 28 is further coupled to a clock signal;
the replicating circuit block 16 comprises a set of resistive elements R₁, Rᵢ, R_{N} and a set of switches S₁, Sᵢ, S_{N} coupled to a capacitive element C;
a state of each switch in the set of switches is controlled by on at least one bit Vc(1),...,Vc(i), ...,Vc(N) of the feedback/indicator signal Vc; and
in a closed state, a switch in the set of switches is configured to bypass a resistive element in the set of resistive elements.

As exemplified herein, an electronic device comprises:
a circuit 10 as per the present disclosure, and
a modulating circuit block 11 coupled to the switching circuit block of the circuit 10 to provide the modulating signal thereto,
preferably wherein the electronic device is a class-D amplifier device and the impedance load is that of a loudspeaker.

As exemplified herein, a method comprises:
applying a driving signal at a control node of at least one switching circuit block, producing at least one modulated signal at a respective switching node of the at least one switching circuit as a result;
applying demodulating processing at a low-pass cut-off frequency to the at least one modulated signal, providing a demodulated signal to a load impedance as a result;
applying at least one replica of the demodulating processing to the at least one modulated signal, providing at least one reference signal as a result;
applying signal processing to the at least one demodulated signal and to the reference signal;
providing at least one indicator signal indicative of a variation of the cut-off frequency of the demodulating processing.

Preferably, applying signal processing (93, 94, 96) further comprises:
applying pass-band filtering (24) to the demodulated signal (RPL; RPL_A, RPL_B) and to the at least one reference signal (REF; REF_A, REF_B), and
applying signal amplification (96) to a difference (ε) between the power of the at least one pass-band filtered demodulated signal (RPL_F) and the power of the at least one pass-band filtered reference signal (REF_F)

For instance, the method further comprises coupling, via at least one feedback loop, the at least one demodulator circuit to the control node of the at least one switching circuit block via a modulating circuit block, and varying a loop gain frequency response based on the indicator signal.

It will be otherwise understood that the various individual implementing options exemplified throughout the figures accompanying this description are not necessarily intended to be adopted in the same combinations exemplified in the figures. One or more embodiments may thus adopt these (otherwise non-mandatory) options individually and/or in different combinations with respect to the combination exemplified in the accompanying figures.

Without prejudice to the underlying principles, the details and embodiments may vary, even significantly, with respect to what has been described by way of example only, without departing from the extent of protection. The extent of protection is defined by the annexed claims.

## Claims

1. A circuit (10; 10'), comprising:
at least one switching circuit block (12; 12A, 12B) comprising:
a supply node (VCC) configured to receive a supply voltage level from an energy source referred to ground (GND);
a control node (DRV) configured to receive an input signal;
a switching node (SW) configured to provide a modulated signal (PWM);
a first electronic switch (HS) having a current flow path therethrough coupled interposed to the supply node (VCC) and the switching node (SW), and
a second electronic switch (LS) having a current flow path therethrough coupled interposed to the switching node (SW) and ground (GND),
wherein the first electronic switch (HS) and the second electronic switch (LS) are configured to be made selectively conductive and non-conductive based on the input signal received at the second node (DRV), providing at least one modulated signal (PWM) at the switching node (SW) as a result;
at least one demodulator circuit block (14; 14A, 14B) coupled to the switching node (SW) of the at least one switching circuit block (12) to receive the at least one modulated signal (PWM), the demodulator circuit (14) configured to apply low-pass filtering processing to the modulated signal (PWM) at a low-pass cut-off frequency, providing at least one demodulated signal (RPL; RPL_A, RPL_B) to a load impedance (Rload) as a result;
at least one replicating circuit block (16; 16A, 16B) coupled to the switching node (SW) of the at least one switching circuit block (12) to receive the at least one modulated signal (PWM), the at least one replicating circuit (16; 16A, 16B) configured to apply to the at least one modulated signal (PWM) a replica of the low-pass filtering processing of the at least one demodulator circuit (14; 14A, 14B), providing at least one reference signal (REF; REF_A, REF_B) as a result;
at least one signal processing circuit block (20; 20A, 20B) coupled to the at least one demodulator circuit (14; 14A, 14B) and to the at least one replicating filter circuit (16; 16A, 16B), the at least one signal processing circuit block (20; 20A, 20B) configured to apply signal processing to the at least one demodulated signal (RPL; RPL_A, RPL_B) and to the at least one reference signal (REF; REF_A, REF_B), providing at least one indicator signal (Vc, Vpp; Vc_A, Vc_B) indicative of a variation of the cut-off frequency of the at least one demodulator circuit block (14; 14A, 14B) as a result.

2. The circuit (10; 10') of claim 1, comprising:
at least one feedback loop (FL) coupling the at least one demodulator circuit (14; 14A, 14B) to the control node (DRV) of the at least one switching circuit block (12; 12A, 12B) via a modulating circuit block (11), and
varying a loop gain frequency response (|Gloop|) based on the indicator signal (Vc, Vpp; Vc_A, Vc_B).

3. The circuit (10; 10') of claim 1 or claim 2, comprising:
a first switching circuit block (12A) and a second switching circuit block (12B) each comprising a respective supply node (VCC) configured to receive a supply voltage level from an energy source referred to ground (GND), a respective control node (DRV) configured to receive an input signal, and a respective switching node (SW) configured to provide a respective modulated signal (PWM);
a first demodulator circuit block (14A) coupled to the switching node of the first switching circuit block (12A) to receive a first modulated signal (PWM) and a second demodulator circuit block (14B) coupled to the switching node of the second switching circuit block (12B) to receive a second modulated signal (PWM);
a first replicating circuit block (16A) coupled to the switching node (SW) of the first switching circuit block (12A) to receive the first modulated signal and a second replicating circuit block (16B) coupled to the switching node of the second switching circuit block to receive the second modulated signal,
the first (16A), resp. second (16B) replicating circuits configured to apply to the first, resp. second, modulated signal a replica of the low-pass filtering processing of the first (14A), resp. second (14B), demodulator circuit, providing a first (REF_A), resp. second (REF_B), reference signal as a result;
wherein the signal processing circuit block (20_A, 20_B) comprises:
a first signal processing circuit block (20_A) configured to perform a comparison of a first power signal based on the first demodulated signal (RPL_A) and a second power signal based on the first reference signal (REF_A), providing a first indicator signal (Vc_A) as a result of the comparison, the first indicator signal (Vc_A) indicative of a variation of the cut-off frequency of the first demodulator circuit block (14A), and
a second signal processing circuit block (20_B) configured to perform a comparison of a third power signal based on the second demodulated signal (RPL_B) and a fourth power signal based on the second reference signal (REF_B), providing a second indicator signal (Vc_B) as a result of the comparison, the second indicator signal (Vc_B) indicative of a variation of the cut-off frequency of the second demodulator circuit block (14B).

4. The circuit (10; 10') of any one of the previous claims, wherein the signal processing circuit block (20; 20_A, 20_B) comprises:
a first signal processing branch (22A) configured to apply a first signal processing (24A, 26A) to the demodulated signal (RPL) received from the at least one demodulator circuit block (14; 14A, 14B), providing a first processed signal (RPL_P) as a result;
a second signal processing branch (22B) configured to apply a second signal processing (24B, 26B) to the reference signal (REF) received from the at least one replicating circuit block (16; 16A, 16B), providing a second processed signal (REF_P) as a result; and
a differential amplifier circuit block (28) having a first error amplifier node coupled to the first signal processing branch (22A) to receive first processed signal (RPL_P) and a second error amplifier node coupled to the second signal processing branch (22B) to receive the second processed signal (REF_P), the error amplifier (28) configured to produce the at least one indicator signal (Vc, Vpp; Vc_A, Vc_B) based on a difference (ε) between the first processed signal (RPL_P) and the second processed signal (REF_P).

5. The circuit (10; 10') of claim 4, wherein the first signal processing branch (22A) and the second signal processing branch (22B) each comprise:
a pass-band filter circuit block (24) configured to apply pass-band filtering to the received input signal (RPL, REF), providing a pass-band filtered signal (RPL_F, REF_F) as a result, and
a power detecting circuit block (26) coupled to the pass-band filter circuit block (24) and configured to apply power detection processing to the pass-band filtered signal (RPL_F, REF_F), providing the processed signal (RPL_P, REF_P) as a result.

6. The circuit (10; 10') of claim 5, wherein:
the error amplifier circuit block (28) comprises an integrator, and
the power detecting circuit block (26) comprises:
multiplier circuitry (27; 27A, 27B) configured to provide a power signal by multiplying the pass-band filtered signal (RPL_F, REF_F) by itself or by detecting a sign of the pass-band filtered signal (RPL_F, REF_F) and multiplying the pass-band filtered signal (RPL_F, REF_F) by the detected sign; and/or
envelope detecting circuitry configured to measure a peak power of the pass-band filtered signal (RPL_F, REF_F).

7. The circuit (10; 10') of any one of the previous claims, wherein:
the signal processing circuit (20; 20_A, 20_B) is configured to provide the indicator signal (Vc, Vpp; Vc A, Vc B) back to the replicating filter circuit block (16), and
a cut-off frequency of the replicating circuit block (16) varies based on the received indicator signal (Vc, Vpp; Vc A, Vc B), preferably wherein the at least one replicating circuit block (16) comprises active filter circuitry (R1, C1, R2, C2; Q16).

8. The circuit (10; 10') of claim 7, wherein the at least one replicating circuit block (16) comprises an active circuit element (Q16), preferably comprising a transistor, having a control node configured to receive the indicator signal (Vc, Vpp; Vc_A, Vc_B) and a current flow path therethrough coupled to a capacitive element (C16), wherein a resistance of the active circuit element (Q16) varies based on the indicator signal (Vc, Vpp; Vc A, Vc B).

9. The circuit (10; 10') of claims 3 and 7, wherein:
the error amplifier circuit block (28) is further coupled to a clock signal (CK);
the replicating circuit block (16) comprises a set of resistive elements (R₁, Rᵢ, R_{N}) and a set of switches (S₁, Sᵢ, S_{N}) coupled to a capacitive element (C);
a state of each switch in the set of switches (S₁, Sᵢ, S_{N}) is controlled by on at least one bit (Vc(1), Vc(i), Vc(N)) of the indicator signal (Vc, Vpp; Vc_A, Vc_B); and
in a closed state, a switch in the set of switches (S₁, Sᵢ, S_{N}) is configured to bypass a resistive element in the set of resistive elements (R₁, Rᵢ, R_{N}).

10. An electronic device (100), comprising:
a circuit (10; 10') according to any one of the previous claims, and
a modulating circuit block (11) coupled to the switching circuit block (12) of the circuit (10; 10') to provide the modulating signal (DRV) thereto,
preferably wherein the electronic device (100) is a class-D amplifier device and the impedance load (Rload) is that of a loudspeaker.

11. A method, comprising:
applying a driving signal (DRV) at a control node of at least one switching circuit block (12; 12A, 12B), producing (90) at least one modulated signal (PWM) at a respective switching node (SW) of the at least one switching circuit (12; 12A, 12B) as a result;
applying (91) demodulating processing (14; 14A, 14B) at a low-pass cut-off frequency to the at least one modulated signal (PWM), providing a demodulated signal (RPL; RPL_A, RPL_B) to a load impedance (Rload) as a result;
applying (92) at least one replica (16; 16A, 16B) of the demodulating processing (14; 14A, 14B) to the at least one modulated signal (PWM), providing at least one reference signal (REF; REF_A, REF_B) as a result;
applying signal processing (93, 94, 96) to the at least one demodulated signal (RPL; RPL_A, RPL_B) and to the reference signal (REF; REF_A, REF_B),
providing (97, 98) at least one indicator signal (Vc, Vpp; Vc_A, Vc_B) indicative of a variation of the cut-off frequency of the demodulating processing (14; 14A, 14B).
preferably wherein applying signal processing (93, 94, 96) further comprises:
applying pass-band filtering (24) to the demodulated signal (RPL; RPL_A, RPL_B) and to the at least one reference signal (REF; REF_A, REF_B), and
applying signal amplification (96) to a difference (ε) between the power of the at least one pass-band filtered demodulated signal (RPL_F) and the power of the at least one pass-band filtered reference signal (REF_F)

12. The method of claim 11, comprising:
coupling, via at least one feedback loop (FL), the at least one demodulator circuit (14; 14A, 14B) to the control node (DRV) of the at least one switching circuit block (12; 12A, 12B) via a modulating circuit block (11), and
varying a loop gain frequency response (|Gloop|) based on the indicator signal (Vc, Vpp; Vc_A, Vc_B).
